# EUROPEAN PATENT APPLICATION

(11) **EP 2 387 070 A1**
(43) Date of publication of application: **16.11.2011**
(21) Application number: 09744589.4
(22) Date of filing: 06.01.2009
(51) Int. Cl.: H01L 23/34

(54) **DEVICE FOR ENERGY CONVERSION AND EQUIPMENT FOR ENERGY CONVERSION**

(71) Applicant: Chen, Jenshyan, Taiwan 300 (CN)
(72) Inventor: LIN, Chung-zen, Taiwan (CN)
(74) Representative: Goddar, Heinz J.
(86) International application number: PCT/CN2009/000017
(87) International publication number: WO 2010/078691

(57) **Abstract**

The invention discloses an energy transducing apparatus and an energy transducing equipment grouping a plurality of the energy transducing apparatuses. The energy transducing apparatus includes a heat pipe, a first heat-dissipating member, a second heat-dissipating member, and an energy transducing member. The heat pipe includes a contact portion and a flat portion. The first heat-dissipating member includes a plurality of fins. The second heat-dissipating member is connected to the first heat-dissipating member to form an accommodating space. The contact portion is accommodated in the accommodating space and contacts both the first heat-dissipating member and the second heat-dissipating member. The energy transducing member contacts the flat portion. Thereby, heat generated in operation by the energy transducing member is conducted through the flat portion to the heat pipe and then is dissipated through the first heat-dissipating member, the second heat-dissipating member, and the fins.

## Description

### BACKGROUND OF THE INVENTION

### 1. Field of the invention

The present invention relates to an energy transducing apparatus and an energy transducing equipment, and more particularly, relates to an energy transducing apparatus and an energy transducing equipment using a heat pipe and a combinative heat-dissipating module for dissipating heat.

### 2. Description of the prior art

With the depletion of crude oil, the need for alternative energy becomes important. In consideration of ecosystem impact, solar energy, wind power, and water power become major topics of the development. Therein the solar energy is the most plentiful energy. However, in a process of transducing solar energy, not all of incident light could be absorbed by a solar cell to be converted into electric current completely. A half of the energy of photons is too low (lower than a band gap of a semiconductor) to output a current. Although the other half of the energy of photons is absorbed, except for the required energy for generate electro hole pairs, about a half of the absorbed energy is lost by heat. The lost heat will affect the solar cell (e.g. raising the working temperature of the solar cell). The too high working temperature will lead to the lower photoelectric conversion efficiency of the solar cell. With such a vicious circle, more and more solar energy will be lost by heat and the photoelectric conversion efficiency of the solar cell will decrease further.

On the other hand, the usage of energy focuses on how to save energy. With the development of semiconductor light-emitting devices, the light-emitting diode (LED) has become a new light source and has several advantages, such as power save, seismic resistance, quick reaction, and so on. Therefore, LEDs are widely used as indicator lights on electronic devices, and using LEDs as a light source of an illumination product becomes a trend. In order to raise the illumination, high-power LEDs are used as the light source in the illumination product. However it results in other problems, for example, heat dissipation. If the heat generated by the LEDs in operation could not be dissipated instant, the LEDs will suffer a thermal impact so as to reduce their service life and light-emitting efficiency. It is negative to saving energy.

Therefore, in the prior art, the heat generated by converting photo energy into electricity could not be dissipated efficiently, so that the photoelectric conversion efficiency of the solar cell could not increase or be maintained, and the solar cell or LED may even be damaged thereby.

### SUMMARY OF THE INVENTION

The invention discloses an energy transducing apparatus for efficiently dissipating heat generated in operation, so that the energy transducing apparatus could be prevented from a thermal impact, the photoelectric conversion efficiency could be maintained, and the service life of the energy transducing apparatus could be extended.

The energy transducing apparatus of the invention includes a heat pipe, a first heat-dissipating member, a second heat-dissipating member, and an energy transducing member. The heat pipe includes a contact portion and a flat portion. The contact portion extends along a direction. The first heat-dissipating member includes a plurality of fins parallel to the direction substantially. The second heat-dissipating member and the first heat-dissipating member are connected to form an accommodating space. The contact portion is accommodated in the accommodating space and contacts both the first heat-dissipating member and the second heat-dissipating member. The energy transducing member (for example, a solar cell or a light-emitting diode) contacts the flat portion. Therein, the first heat-dissipating member includes a first semi-groove along the direction, the second heat-dissipating member includes a second semi-groove along the direction, and the first semi-groove and the second semi-groove form the accommodating space.

The heat generated in operating in the energy transducing member could be conducted to the heat pipe through the flat portion contacting the energy transducing member. The conducted heat is transmitted in the heat pipe and then conducted through the contact portion to the first heat-dissipating member and the second heat-dissipating member. Thereby, the heat could be dissipated by the first heat-dissipating member and the second heat-dissipating member. Therein, the fins of the first heat-dissipating member are useful to dissipating heat, so as to raise the heat-dissipating efficiency of the first heat-dissipating member.

Additionally, the second heat-dissipating member includes a circuit accommodating space for accommodating a control module circuit controlling the energy transducing member. It is of benefit to the modularization of the energy transducing apparatus. The fins parallel to the direction could improve the influence of the setting angle of the energy transducing apparatus on heat dissipation.

The energy transducing equipment of the invention includes a frame and a plurality of the energy transducing apparatuses. The frame could include a panel with a plurality of holes. The energy transducing apparatuses are disposed on the frame and correspond to the holes. The energy transducing equipment further includes a control module circuit disposed on the frame and electrically connected to the energy transducing apparatuses. The energy transducing apparatuses of the energy transducing equipment are engaged to and mounted on the frame, and they are synchronously controlled by the single control module circuit to perform grouping effect. Further, the energy transducing equipment could become a self-sufficient charging/light-emitting system by equipping with the energy transducing apparatuses of different conversion modes.

The advantage and spirit of the invention may be understood by the following recitations together with the appended drawings.

### BRIEF DESCRIPTION OF THE APPENDED DRAWINGS

FIG. 1 illustrates an energy transducing apparatus according to a first preferred embodiment of the invention.
FIG. 2 illustrates a cross section of the energy transducing apparatus.
FIG. 3A illustrates the first heat-dissipating member.
FIG. 3B illustrates a tubular body of the second heat-dissipating member.
FIG. 4A illustrates that an optical adjusting member is screwed on a carrier by a thread structure.
FIG. 4B illustrates that the optical adjusting member hooks the carrier by a hook structure.
FIG. 4C illustrates that a hook of the optical adjusting member is engaged to a hook slot of the carrier.
FIG. 5 illustrates that the carrier is screwed on a heat pipe through a thread structure.
FIG. 6A illustrates a plane view of an energy transducing member of the energy transducing apparatus.
FIG. 6B illustrates a cross section of the energy transducing member, the carrier, and a part of the heat pipe along Z-Z line in FIG. 6A.
FIG. 7 illustrates a cross section of the energy transducing member, the carrier, and a part of the heat pipe according to an embodiment.
FIG. 8 illustrates a cross section of the energy transducing member, the carrier, and a part of the heat pipe according to another embodiment.
FIG. 9 illustrates a cross section of the energy transducing member, the carrier, and a part of the heat pipe according to another embodiment.
FIG. 10 illustrates a cross section of the energy transducing member, the carrier and a part of the heat pipe according to another embodiment.
FIG. 11 illustrates an energy transducing apparatus according to a second preferred embodiment.
FIG. 12A illustrates the first heat-dissipating member.
FIG. 12B illustrates the second heat-dissipating member.
FIG. 13A illustrates an energy transducing equipment according to a third preferred embodiment.
FIG. 13B illustrates a partial cross section of the energy transducing equipment.

### DETAILED DESCRIPTION OF THE INVENTION

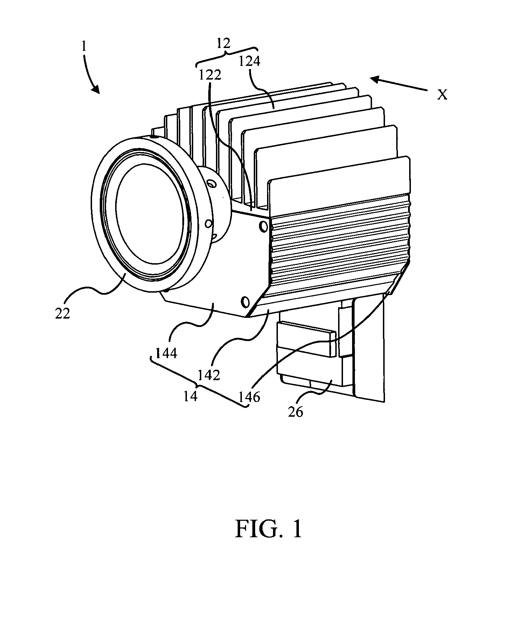

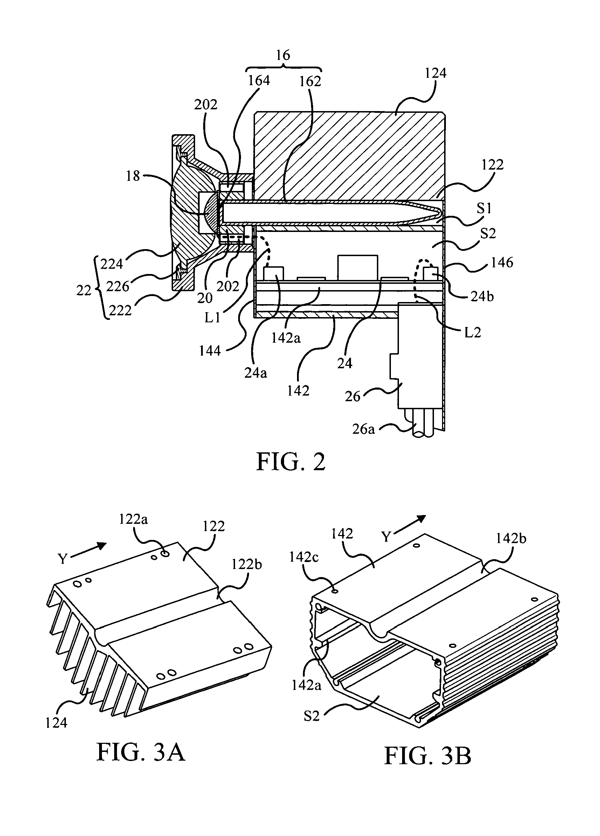

Please refer to FIG. 1 and FIG. 2. FIG. 1 illustrates an energy transducing apparatus 1 according to a first preferred embodiment of the invention. FIG. 2 illustrates a cross section of the energy transducing apparatus 1. The section penetrates the entire energy transducing equipment 1 symmetrically. The visual angle of FIG. 2 is the direction X as shown in FIG. 1, and a control module circuit 24 and a connector 26 are not cut in FIG. 2 for the simplification of the drawing. Additionally, the cross section of an energy transducing member 18 has also been simplified.

According to the first preferred embodiment, the energy transducing apparatus 1 includes a first heat-dissipating member 12, a second heat-dissipating member 14, a heat pipe 16, an energy transducing member 18, a carrier 20, an optical adjusting member 22, a control module circuit 24, and a connector 26. The first heat-dissipating member 12 includes a plate body 122 and several fins 124 extending from the plate body 122. The second heat-dissipating member 14 includes a tubular body 142, a front cover 144, and a rear cover 146. The front cover 144 and the rear cover 146 are engaged to two openings of the tubular body 142 to form an accommodating space S2. The accommodating space S2 accommodates the control module circuit 24 and a part of the connector 26. The control module circuit 24 is disposed on a protrusion 142a of the tubular body 142(please refer to FIG. 3B). Additionally, if the protrusion 142a is formed to be a slide, it is helpful to mounting the control module circuit 24.

The first heat-dissipating member 12 and the second heat-dissipating member 14 are engaged together and form an accommodating space S1. The shape of the accommodating space S1 is a cylinder nearly for accommodating the heat pipe 16. The heat pipe 16 includes a contact portion 162 and a flat portion 164. The contact portion 162 is disposed in the accommodating space S1 and contacts with the first heat-dissipating member 12 and the second heat-dissipating member 14. Additionally, other substances with high thermal conductivity could replace the heat pipe 16.

The carrier 20 is mounted at an end of the heat pipe 16. In principle, the carrier 20 and the flat portion 164 of the heat pipe 16 are coplanar but not limited to it. The energy transducing member 18 is mounted on the carrier 20 and contacts with the flat portion 164, so that the heat generated in operation by the energy transducing member 18 could be conducted through the flat portion 164 to the heat pipe 16, then conducted through the contact portion 162 of the heat pipe 16 to the first heat-dissipating member 12 (including the fins 124 thereof) and the second heat-dissipating member 14, and dissipated outside. The optical adjusting member 22 includes a ring body 222, a lens structure 224, and a fixed ring 226. The ring body 222 is connected to the carrier 20, the lens structure 224 is disposed right opposite to the energy transducing member 18, and the fixed ring 226 is mounted on the ring body 222.

Moreover, the control module circuit 24 includes a circuit board and other related electronic devices. The control module circuit 24 is electrically connected to the energy transducing member 18 by a wire L1 (represented by a bold-faced dotted line in FIG. 2) which is electrically connected to a connector 24a. The carrier 20 thereon forms holes 202 for the wire to pass through. The control module circuit 24 is electrically connected to the connector 26 (e.g. terminal blocks) through a wire L2 (represented by a bold-faced dotted line in FIG. 2) which is electrically connected to a connector 24b. According to the conversion mode of the energy transducing member 18, the connector 26 is connected to a power source through a wire 26a to obtain the required electricity for controlling the operation of the energy transducing member 18 by the control module circuit 24; for example, the conversion mode is to transduce electricity into photo energy (e.g. the energy transduction of LEDs). The connector 26 could alternatively provide electricity to other devices via the wire 26a; for example, the conversion mode is to transduce photo energy into electricity (e.g. the energy transduction of a solar cell).

Please refer to FIG. 3A and FIG. 3B. FIG. 3A illustrates the first heat-dissipating member 12. Relative to the energy transducing apparatus 1 in FIG. 1, the first heat-dissipating member 12 illustrated in FIG. 3A has been turned over for explaining conveniently. FIG. 3B illustrates the tubular body 142 of the second heat-dissipating member 14. As shown in FIG. 3A and FIG. 3B, the plate body 122 of the first heat-dissipating member 12 includes a first semi-groove 122b which is a semicircle and extends along Y direction; the tubular body 142 of the second heat-dissipating member 12 correspondingly includes a second semi-groove 142b which is a semicircle and extends along Y direction. When the first heat-dissipating member 12 is connected to the second heat-dissipating member 14, the first semi-groove 122b and the second semi-groove 142b therefore form the accommodating space S1.

In practical fabrication, the heat pipe 16 could be disposed in the first semi-groove 122b or the second semi-groove 142b. Then, the plate body 122 and the tubular body 142 are connected by screwing screws through holes 122a into threaded holes 142c, and the first heat-dissipating member 12 and the second heat-dissipating member 14 are therefore connected. The heat pipe 16 is also accommodated in the accommodating space S1 formed by the first semi-groove 122b and the second semi-groove 142b. The mounting method for the invention is not limited to the above-mentioned method. Therefore, they (the plate body 122 and the tubular body 142) could also be mounted together by welding or a C-shaped buckle.

If the outer diameter of the heat pipe 16 is little smaller than the inner diameter of the accommodating space S1 or the cross-sectional profile of the heat pipe 16 interfere in dimensions with the cross-sectional profile of the accommodating space S1, the contact portion 162 of the heat-pipe 16, by above-mentioned fabrication, will be compressed to paste on the first heat-dissipating member 12 and the second heat-dissipating member 14 tightly. Therefore, the heat pipe 16 will be deformed, which could not only enhance the connection strength of the heat pipe 14 to both the first heat-dissipating member 12 and the second heat-dissipating member 14 but also increase the contact area of the contact portion 162 to both the first semi-groove 122b and the second semi-groove 142b, so as to increase the thermal conduction efficiency.

Additionally, both the first semi-groove 122b and the second semi-groove 142b do not have to occupy the accommodating space S1 equally. In other words, the first semi-groove 122b could occupy most of the accommodating space S1. For example, if the cross-section of the heat pipe 16 is a rectangle, the appearance of the second semi-groove 142b presents a plane substantially (i.e. the second heat-dissipating member 12 has the unobvious second semi-groove 142b) and the second semi-groove 142b still could form the accommodating space S1 together with the first semi-groove 122b. Therefore, it is enough that the first heat-dissipating member 12 is engaged to the second heat-dissipating member 14 to form the accommodating space S1. It is not necessary that both the first heat-dissipating member 12 and the second heat-dissipating member 14 have a concave and protrusive structure.

Additionally, although the direction Y is a linear direction, it is not limited to this. It could also be a curve. Logically, a connection plane of the first heat-dissipating member 12 and the second heat-dissipating member 14 is a parting plane of the accommodating space S1 for dividing the accommodating space S1 into the first semi-groove 122b and the second semi-groove 142b. In principle, if the accommodating space S1 extends along a curve, the curve lies on the parting plane. In the first preferred embodiment, the fins 124 are parallel to the direction Y. Although the energy transducing apparatus 1 (or the heat pipe 16) is disposed vertically or horizontally, air could flow through the intervals of the fins 124 fluently. Incidentally, each of the fins 124 could also be arranged radially.

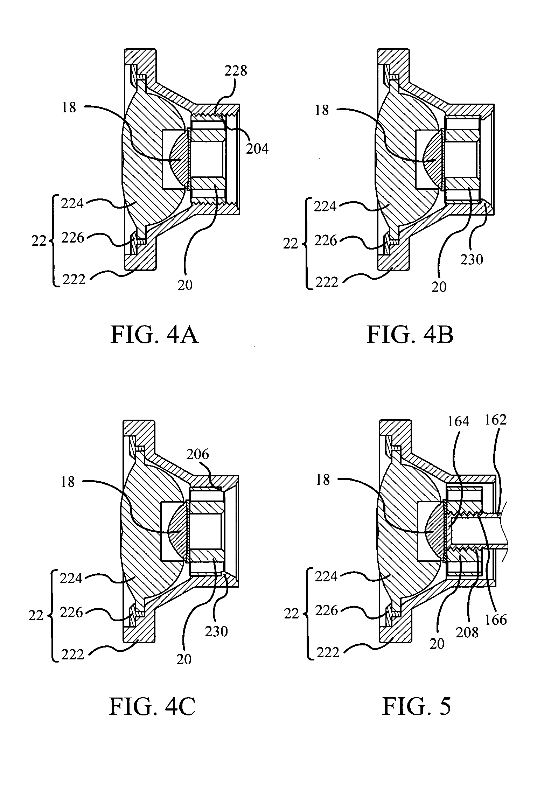

Moreover, the ring body 222 of the optical adjusting member 22 as shown in FIG. 2 could be mounted on the carrier 20 by pasting, clamping or screwing a screw through the ring body 222 into the carrier 20; however, the fixation of the invention is not limited to it. Please refer to FIG. 4A and FIG. 4B. FIG. 4A illustrates that the optical adjusting member 22 is screwed on the carrier 20 by a thread structure. FIG. 4B illustrates that the optical adjusting member 22 hooks the carrier 20 by a hook structure. As shown in FIG.4A, the thread structure primarily consists of an inner thread 228 formed in the ring body 222 and an outer thread 204formed on a side of the carrier 20. Thus, the ring body 222 of the optical adjusting member 22 could be screwed on the carrier 20. Additionally, the thickness of the wall of the thread structure in the carrier 20 is different form that shown in FIG. 2, because the modification for the different connection structure is required.

As shown in FIG. 4B, the hook structure could consists of a hook 230 formed on the ring body 222. The optical adjusting member 22 could be connected to the carrier 20 by hooking the carrier 20 with the hook 230. If a hook slot 206 is formed on the carrier 20 correspondingly, the hook structure consists of the hook 230 and the hook slot 206. When the hook 230 of the optical adjusting member 22 has hooked the hook slot 206 of the carrier 20, the position of the hook 230 is also limited in the hook slot 206 as shown in FIG. 4C. With a proper design of size, the hook slot 206 is able to mount the hook 230 thereon.

Moreover, the carrier 20 shown in FIG. 2 could be mounted at an end of the heat pipe 16 and against the heat pipe 16 by the way of pasting, clamping, or screwing with a screw on the carrier 20; however, the fixation of the invention is not limited to these. Please refer to FIG. 5. FIG. 5 illustrates that the carrier 20 is screwed on the heat pipe 16 through a thread structure. As shown in FIG. 5, the thread structure primarily consists of an inner thread 208 formed in a hole of the carrier 20 and an outer thread 166 formed on the heat pipe 16. Thus, the carrier 20 could be screwed at an end of the heat pipe 16.

Additionally, if the thickness of wall of the heat pipe 16 is thick enough, the outer thread 166 of the heat pipe 16 could be tapped by a traditional tapper. If the thickness of the heat 16 is not able to bear the cutting force or the thickness of wall after the cutting is not able to be screwed by the carrier 20, the outer screw thread 166 could be formed by rolling. The formation could be to form the outer thread 166 with a slight change of the thickness of the wall, and the strength of the outer thread 166 is improved due to the effect of work hardening. It is noticed that FIG. 4A, FIG. 4B, FIG. 4C, and FIG. 5 only illustrate a sketch drawing of the energy transducing member 18 and the details of the energy transducing member 18 are not shown in these figures.

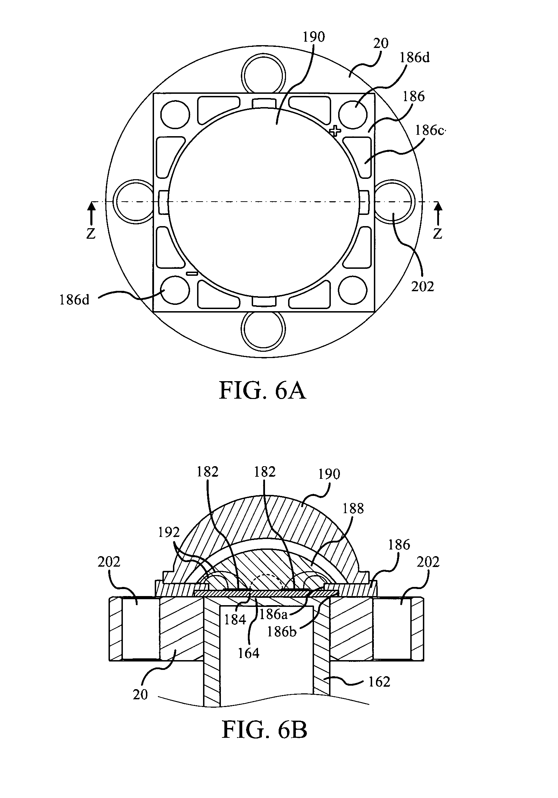

Please refer to FIG. 6A and FIG. 6B. FIG. 6 illustrates a plane view of the energy transducing member 18 and the carrier 20 of the energy transducing apparatus 1. FIG. 6B illustrates a cross section of the energy transducing member 18, the carrier 20, and a part of the heat pipe 16 along line Z-Z in FIG. 6A. According to the first preferred embodiment, the energy transducing member 18 includes energy transducing semiconductor structures 182, a substrate 184 and a base 186. The energy transducing semiconductor structures 182 are disposed on the substrate 184. The base 186 includes a first sunken portion 186a and a second sunken portion 186b connected to the first sunken portion 186a. The substrate 184 contacts the flat portion 164 and is connected to the second sunken portion 186b, and the energy transducing semiconductor structure 182 are exposed out of the first sunken portion 186a.

The energy transducing semiconductor structure 182 is an independent chip and it is mounted on the substrate 184. The energy transducing semiconductor structure 182 is wired to inner electrodes of the base 186 with metal wires 192 and then the energy transducing semiconductor structure 182 is electrically connected to the control module circuit 24 through wires L1 welded to outer electrodes 186c which is connected to the inner electrodes on the base 186 (please also refer to FIG. 2). The energy transducing semiconductor structure 182 and metal wires 192 are mounted or sealed on the substrate 184 by a packing material 188. The base 186 is mounted on the carrier 20 by screwing screws through holes 186d to the carrier 20. The packing material 188 is also able to adjust light. If the contour of the packing material 188 is protrusive as shown in FIG. 6B, the packing material 188 is able to converge light.

According to the first preferred embodiment, the energy transducing member 18 includes a lens 190 disposed on the base 186. The lens 190 is able to converge light, but not limited to it. With a proper design on the curvatures of two sides of the lens 190, the lens 190 is able to converge or scatter light for satisfying different optical adjustment requirements. In practical application, the optical adjustment effect of the energy transducing apparatus 1 also need to consider optical characters of a lens structure 224 of the optical adjusting member 22. What is remarkable is that the lens structure 224 of the optical adjusting member 22 is not limited to a convex lens. Please refer to FIG. 4A, there is a recess at the middle of the lens structure 224 and thus light is converged to become a ring shape roughly by the lens structure 224.

Please refer to FIG. 6A and FIG. 6B. Additionally, the base 186 could be formed by imbedding a lead frame of metal into a mold and then injecting liquid crystal plastic into the mold. Therein, the inner electrodes defined on the lead frame are exposed out of the first sunken portion 186a, and the outer electrodes 186c are exposed out of the base 186. Additionally, the energy transducing semiconductors 182 could be connected in serial by wiring as shown by the dotted line in FIG. 6B. Meantime, the energy transducing semiconductor structure 182 in FIG. 6B only retains one metal wire 192 to be connected to the base 186. If there is a circuit on the substrate 184, for example a semiconductor substrate with a circuit formed in process or a circuit board coated with a metal circuit, the energy transducing semiconductor structure 182 could be wired to the substrate 184 and then electrically connected to the base 186 through the substrate 184. If the substrate 184 is designed not to be a medium for electrical connection, the substrate 184 could be made of a metal material or other materials with high thermal conductivity for raising the thermal conduction efficiency of conducting the heat generated by the energy transducing semiconductor structure 182 to the flat portion 164.

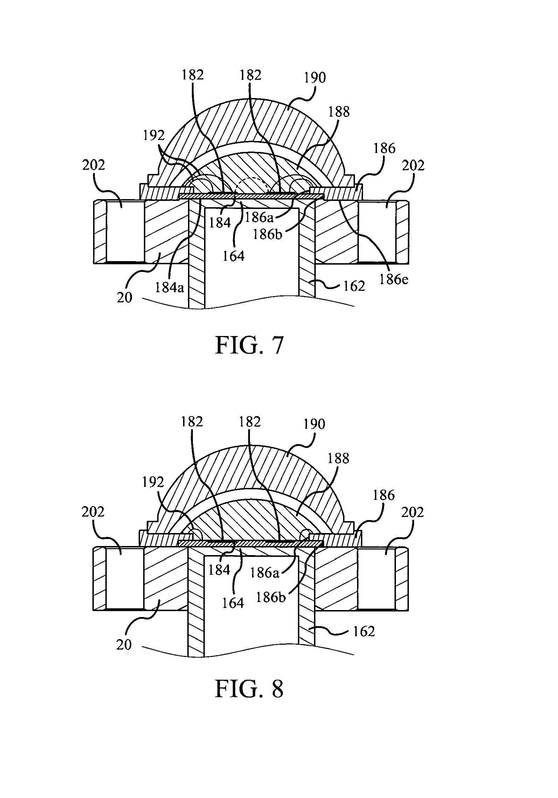

Please refer to FIG.7. FIG. 7 illustrates a cross section of the energy transducing member 18, the carrier 20, and a part of heat pipe 16 according to an embodiment. The difference between the FIG. 7 and FIG. 6 is that the substrate 184 in FIG. 7 is disposed in the second sunken potion 186b entirely. Therefore, the bottom surface 186e of the base 186 slightly protrudes out of the bottom surface 184a (for contacting with the flat portion 164) of the substrate 184. Correspondingly, the flat portion 164 protrudes out of the carrier 20 and the protrusive height of the flat portion 164 is slightly greater than the concave depth of the bottom surface 184a of the substrate 184 for ensuring that the substrate 184 is stuck on the flat portion 164 tightly.

Similarly, the flat portion 164 could slightly protrude out of the carrier 20 and the bottom surface 186e of the base 186 and the bottom surface 184a of the substrate 184 are coplanar. The above purpose for ensuring sticking tightly could also be achieved. In the structure shown in FIG. 6B, if there is a gap between the base 184 and the flat portion 164, a thermal conductive glue could be coated on the bottom surface of the base 186 or the flat portion 164 to be filled with the gap. Of course, in the structure as shown in FIG. 7, the thermal conductive glue could be coated on the bottom surface 186e of the base 186 or the flat portion 164 to be filled with the gap formed due to surface roughness of the bottom surface 186e or the flat portion 164.

Please refer to FIG. 6B and FIG. 8. FIG. 8 illustrates a cross section of the energy transducing member 18, the carrier 20, and a part of the heat pipe 16 according to another embodiment. The difference between FIG. 6B and FIG. 8 is that the energy transducing semiconductor 182 in FIG. 8 is formed on the substrate 184 directly; for example, the substrate 184 itself is a semiconductor substrate (a silicon substrate). Therefore, the energy transducing semiconductor 182 could be integrated to form on the substrate 184 easily in a semiconductor process. Additionally, the electrodes of the energy transducing semiconductor structure 182 formed on the semi-substrate 184 could be integrated on the substrate 184 in advance, so that only two times of wiring are required to the energy transducing semiconductor structure 182. The stability of the fabrication could increase thereby.

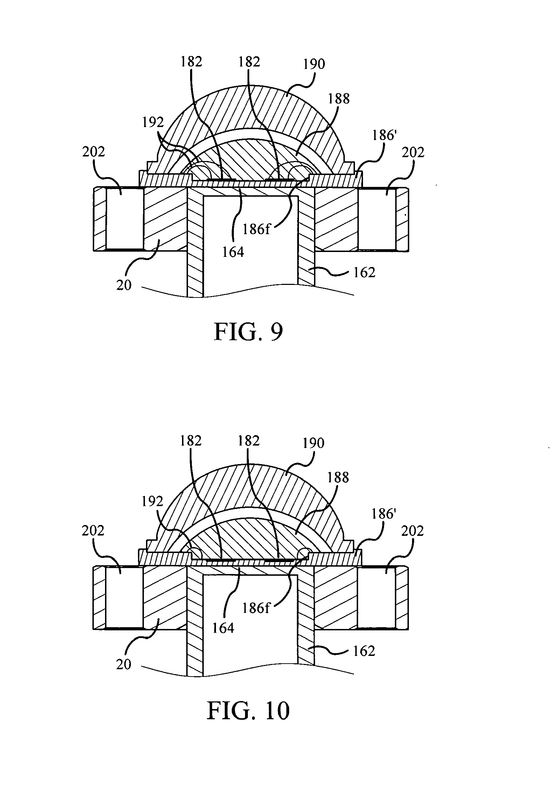

Please refer to FIG. 6B and FIG. 9. FIG. 9 illustrates a cross section of the energy transducing member 18, the carrier 20, and a part of the heat pipe 16 according to another embodiment. The difference between FIG. 9 and FIG. 6B is that the energy transducing semiconductor structure 182 in FIG. 9 is disposed directly on a base 186' having a recess 186f rather than on the substrate 184 as shown in FIG. 6B. Additionally, in practical application, the base 186' could be a plate where the energy transducing semiconductor 182 is disposed directly. The description about the energy transducing member 18 in FIG. 6B is also applied here, and it will no longer be explained.

Please refer to FIG. 9 and FIG. 10. FIG. 10 illustrates a cross section of the energy transducing member 18, the carrier 20 and a part of the heat pipe 16 according to another embodiment. The difference between FIG. 6B and FIG. 10 is that the energy transducing semiconductor structure 182 in FIG. 10 is formed directly on a base 186'. Of course, in practical application, the base 186' could be a plate. The description about the energy transducing member 18 in FIG. 8 is also applied here, and it will no longer be explained.

In the above-mentioned embodiments, when the energy transducing semiconductor structure 182 is a light-emitting diode semiconductor structure, the energy transducing apparatus 1 of the invention could be used as an illuminating apparatus; when the energy transducing semiconductor 182 is a solar cell semiconductor structure, the energy transducing apparatus 1 of the invention could be used as a solar cell. Of course, the energy transducing member 18 could include both a light-emitting diode semiconductor structure and a solar cell semiconductor structure, and the control circuit 24 has a capacitor with enough capacity for storing electricity. Thus, the energy transducing apparatus 1 of the invention could charge the capacity by the solar cell semiconductor structure in the daytime, and the light-emitting diode semiconductor structure could be powered by the stored electricity in the capacity to illuminate in the nighttime.

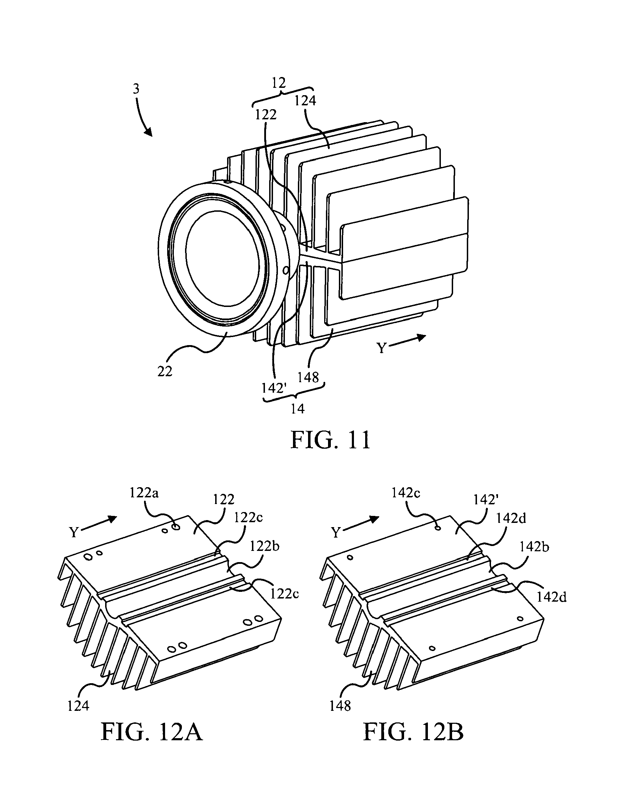

Please refer to FIG. 1, FIG. 2, and FIG. 11. The FIG. 11 illustrates an energy transducing apparatus 3 according to a second preferred embodiment. The difference between the energy transducing apparatus 1 shown in FIG. 1 and the energy transducing apparatus 3 is that the second heat-dissipating member 14 and the first heat-dissipating member 12 (including a plate 142' and fins 148 extended from the plate 142') of the energy transducing apparatus 3 are symmetrical. Because the second heat-dissipating member 14 of the energy transducing apparatus 3 does not include the accommodating space S2 (as shown in FIG. 2) for accommodating the control module circuit 24, the energy transducing apparatus 3 does not include the control module circuit 24 and the connector 26 in principle. However, the energy transducing apparatus 3 could be connected to an electrical box at a rear end (relative to the front end where the optical adjusting member 22 is disposed) of the first heat-dissipating member 12 and the second heat-dissipating member 14 for accommodating the control module circuit 24 and the connector 26.

Please refer to FIG. 12A and FIG. 12B. FIG. 12A and FIG. 12B illustrates the first heat-dissipating member 12 and the second heat-dissipating member 14 respectively. Although the second heat-dissipating member 14 does not include the accommodating space S2 of the energy transducing apparatus 1, the first heat-dissipating member 12 and the second heat-dissipating member 14 of the energy transducing apparatus 3 include semi-channels 122c and 142d respectively. After the first heat-dissipating member 12 is engaged to the second heat-dissipating member 12, two channels are formed thereby for wires electrically connected to the energy transducing member 18 to pass through. If any description about devices with same names in the above-mentioned embodiments could be applied to the second preferred embodiment, the description is also applied here. It is no longer to be explained.

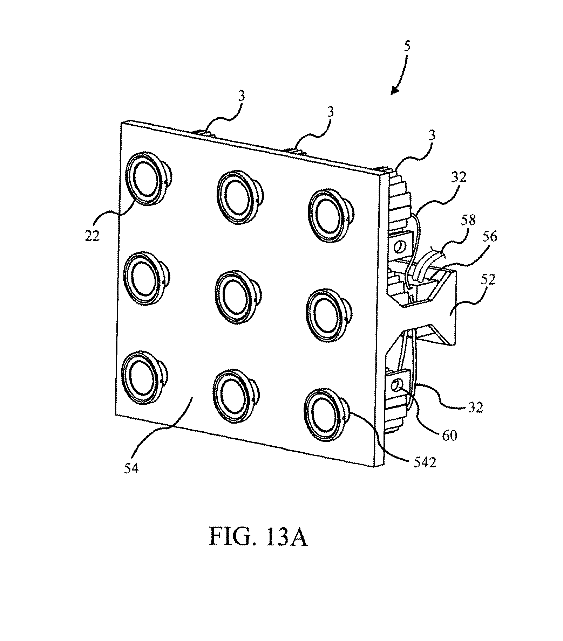

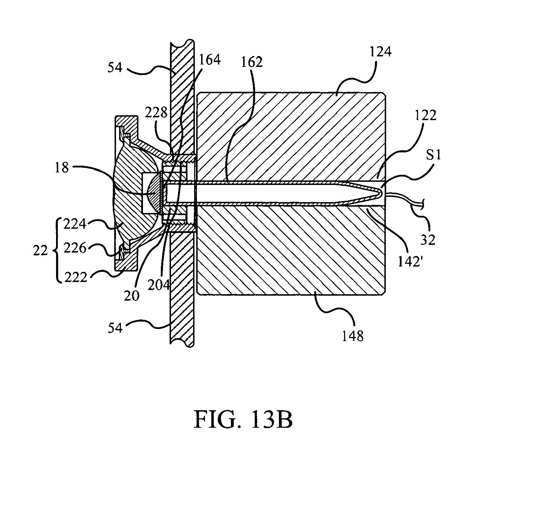

Please refer to FIG. 13A and FIG. 13B. FIG. 13A illustrates an energy transducing equipment 5 according to a third preferred embodiment. FIG. 13B illustrates a partial cross section of the energy transducing equipment 5 and it only illustrates the relative structure of the energy transducing apparatus 3 and a panel 54. The energy transducing equipment 5 includes a frame 52 and several energy transducing apparatuses 3 fixed on the frame 52. In other words, the energy transducing equipment 5 is a group of the energy transducing apparatuses.

The frame 52 includes a panel 54 which includes several holes 542 corresponding to the several energy transducing apparatuses 3. An outer thread 204 of the carrier 20 of each of the energy transducing apparatuses 3 is exposed out of the corresponding hole 542. Thus, the inner thread 228 of the optical adjusting member 22 of each of the energy transducing apparatuses 3 could be engaged with the outer thread 204 from the outside of the panel 54. The energy transducing apparatus 5 includes a control module circuit 56 which is mounted on the frame 52 and is electrically connected to the energy transducing apparatuses 3 through wires 32. Therefore, the energy transducing apparatuses 3 share the same circuit control circuit 56. The control module circuit 56 is electrically connected to an outer power supply through a wire 58 for obtaining required electricity or providing electricity to other apparatuses. Additionally, the frame 52 could be mounted on other mounts through a mounting portion 60.

Additionally, although the energy transducing equipment 5 includes a control module circuit 56, the framework of the energy transducing equipment 5 also suits for the energy transducing apparatus 1 (Please refer to FIG. 1). Because the energy transducing apparatus 1 has the individual control module circuit 24, the control functions of the control module circuit 56 could be simplified thereby. Moreover, it is not necessary for the energy transducing equipment 5 to include the energy transducing apparatuses 3 with the same energy conversion mode. In other word, the energy transducing equipment 5 could include some energy transducing apparatuses 3 which convert photo energy into electricity (light-emitting diode semiconductor structure)and some energy transducing apparatuses 3 which convert electricity into photo energy (solar cell semiconductor structure) for both illumination and storing energy and further becomes an self-sufficient charging/light-emitting system. In this case, the wire 58 could be omitted in principle.

To sum up, the energy transducing apparatus of the invention has a combination heat-dissipating structure, which is helpful to assembling a heat pipe to decrease contact thermal resistance and raise the thermal conduction efficiency. Moreover, the fins of the energy transducing apparatus are disposed parallel to the heat pipe to reduce the influence of airflow, which passes by the fins, being obstructed resulting from the setting angle of the energy transducing apparatus. The energy transducing apparatuses of the energy transducing equipment are engaged to the frame and synchronously controlled by a single control module circuit for performing grouping effect. Further, the energy transducing equipment could be equipped with energy transducing apparatuses having different energy conversion modes so as to be a self-sufficient charging/light-emitting system.

With the example and explanations above, the features and spirits of the invention will be hopefully well described. Those skilled in the art will readily observe that numerous modifications and alterations of the device may be made while retaining the teaching of the invention. Accordingly, the above disclosure should be construed as limited only by the metes and bounds of the appended claims.

## Claims

1. An energy transducing apparatus, comprising:
a heat pipe comprising a contact portion and a flat portion, wherein the contact portion extends along a direction;
a first heat-dissipating member comprising a plurality of first fins, wherein the first fins are parallel to the direction substantially;
a second heat-dissipating member connected to the first heat-dissipating member to form an accommodating space, the contact portion being accommodated in the accommodating space and contacting both the first heat-dissipating member and the second heat-dissipating member; and
an energy transducing member contacting the flat portion,
wherein the first heat-dissipating member comprises a first semi-groove along the direction, the second heat-dissipating member comprises a second semi-groove along the direction, and the first semi-groove and the second semi-groove form the accommodating space.

2. The energy transducing apparatus of claim 1, wherein the second heat-dissipating member comprises a plurality of second fins parallel to the direction substantially.

3. The energy transducing apparatus of claim 1, wherein the second heat-dissipating member comprises a circuit accommodating space for accommodating a control module circuit for controlling the energy transducing member.

4. The energy transducing apparatus of claim 3, further comprising a connector, the connector being exposed to the second heat-dissipating member and being electrically connected to the control module circuit.

5. The energy transducing apparatus of claim 3, wherein the second heat-dissipating member comprises a tubular body, a front cover and a back cover, the front cover and the back cover are engaged to two sides of the tubular body for forming the circuit accommodating space.

6. The energy transducing apparatus of claim 1, wherein the first heat-dissipating member and the second heat-dissipating member press the contact portion tightly.

7. The energy transducing apparatus of claim 1, wherein the energy transducing member comprises an energy transducing semiconductor structure, a substrate, and a base, the energy transducing semiconductor structure is disposed on the substrate, and the base is connected to the substrate such that the energy transducing semiconductor structure is exposed.

8. The energy transducing apparatus of claim 7, wherein the energy transducing semiconductor structure is formed on the substrate.

9. The energy transducing apparatus of claim 7, wherein the energy transducing semiconductor structure is a chip and is mounted on the substrate.

10. The energy transducing apparatus of claim 7, wherein the energy transducing semiconductor structure is a light-emitting diode semiconductor structure or a solar cell semiconductor structure.

11. The energy transducing apparatus of claim 7, wherein the base comprise a first sunken portion and a second sunken portion connected to the first sunken portion, the substrate contacts the flat portion and is connected to the second sunken portion, and the energy transducing semiconductor structure is exposed to the first sunken portion.

12. The energy transducing apparatus of claim 1, wherein the energy transducing member comprises an energy transducing semiconductor structure and a base and the energy transducing semiconductor structure is on the base.

13. The energy transducing apparatus of claim 12, wherein the base comprises a recess and the energy transducing semiconductor structure is in the recess.

14. The energy transducing apparatus of claim 12, wherein the energy transducing semiconductor structure is formed on the base.

15. The energy transducing apparatus of claim 12, wherein the energy transducing semiconductor structure is a chip and is mounted on the base.

16. The energy transducing apparatus of claim 12, wherein the energy transducing semiconductor structure is a light-emitting diode semiconductor structure or a solar cell semiconductor structure.

17. The energy transducing apparatus of claim 1, further comprising a carrier, the carrier being connected to the heat pipe, wherein the energy transducing member is mounted on the carrier, so that the energy transducing member contacts the flat portion.

18. The energy transducing apparatus of claim 17, further comprising an optical adjusting member connected to the carrier.

19. The energy transducing apparatus of claim 18, wherein a side of the carrier comprises a screw thread structure, so that the optical adjusting member is screwed on the carrier through the screw thread structure.

20. The energy transducing apparatus of claim 18, wherein the optical adjusting member hooks the carrier by a hooking structure.

21. The energy transducing apparatus of claim 18, wherein the optical adjusting member comprises a lens structure right opposite to the energy transducing member.

22. An energy transducing equipment, comprising:
a frame comprising a panel, the panel comprising a plurality of holes; and
a plurality of energy transducing apparatuses disposed on the frame, each of the energy transducing apparatuses corresponding to one of the holes and comprising:
a heat pipe comprising a contact portion and a flat portion, wherein the contact portion extends along a direction;
a first heat-dissipating member comprising a plurality of first fins, wherein the first fins are parallel to the direction substantially;
a second heat-dissipating member connected to the first heat-dissipating member to form an accommodating space, the contact portion being accommodated in the accommodating space and contacting both the first heat-dissipating member and the second heat-dissipating member; and
an energy transducing member contacting the flat portion,
wherein the first heat-dissipating member comprises a first semi-groove along the direction, the second heat-dissipating member comprises a second semi-groove along the direction, and the first semi-groove and the second semi-groove form the accommodating space.

23. The energy transducing equipment of claim 22, wherein each of the energy transducing apparatus comprises a carrier connected to the heat pipe and the energy transducing member is mounted on the carrier, so that the energy transducing member contacts the flat portion.

24. The energy transducing equipment of claim 23, wherein each of energy transducing equipment comprises an optical adjusting member, the carrier comprises a screw thread structure exposed to the corresponding hole, and the optical adjusting member is screwed on the carrier through the screw thread structure.

25. The energy transducing equipment of claim 22, further comprising a control module circuit, the control module circuit being disposed on the frame and being electrically connected to the energy transducing apparatuses.
